# EUROPÄISCHE PATENTSCHRIFT

(11) **EP 1 652 415 B1**
(45) Veröffentlichungstag und Bekanntmachung des Hinweises auf die Patenterteilung: **14.05.2008**
(21) Anmeldenummer: 04766277.0
(22) Anmeldetag: 21.07.2004
(51) Int. Cl.: H05K 13/04

(54) **VORRICHTUNG ZUM BESTÜCKEN VON FLACHEN SUBSTRATEN MIT ELEKTRISCHEN BAUELEMENTEN**
DEVICE FOR EQUIPPING FLAT SUBSTRATES WITH ELECTRICAL COMPONENTS
DISPOSITIF POUR EQUIPER DES SUPPORTS PLATS DE COMPOSANTS ELECTRIQUES

(30) Priorität: 08.08.2003 DE 10336609
(43) Veröffentlichungstag der Anmeldung: 03.05.2006
(73) Patentinhaber: SIEMENS AKTIENGESELLSCHAFT, 80333 München (DE)
(72) Erfinder: MEHDIANPOUR, Mohammad, 81829 München (DE)
(86) Internationale Anmeldenummer: PCT/EP2004/051562
(87) Internationale Veröffentlichungsnummer: WO 2005/015972

(56) Entgegenhaltungen:
- DE-A1- 19 707 267

## Beschreibung

Die Erfindung bezieht sich auf eine Vorrichtung zum Bestücken von flachen Substraten mit elektrischen Bauelementen,wobei entlang einer Außenseite eines Führungskörpers der Vorrichtung parallel zur Substratebene ein Positionierorgan linear verschiebbar geführt ist.

Eine derartige Vorrichtung ist z.B. durch die EP0939584 A bekannt geworden. Danach ist ein in einer zum Substrat parallelen Arbeitsebene waagerecht x-y-verfahrbarer Bestückkopf zum Handhaben der Bauelemente quer verschiebbar an einem Positionierarm geführt. Dieser ist auf seiner Oberseite an einem stationären rohrartigen Träger längs verschiebbar geführt, der an beiden Enden an vertikalen Säulen eines Chassis abgestützt ist. Beim schnellen Verfahren des Bestückkopfes und vor allem des Positionierarms entstehen Massenkräfte, die in den relativ schmalen Säulen zu elastischen Verformungen und Schwingungen führen können, die die Positioniergenauigkeit verringern und den Positionierzyklus verzögern können. Die zwischen dem Träger und dem Positionierarm ausgebildete Führungsebene verläuft parallel zur Substratebene in waagerechter Richtung.

Eine aus DE 10025443 A bekannte Bestückvorrichtung weist einen plattenförmigen Träger auf, auf dessen zur Bestückebene parallelen Unterseite ein Positionierarm verfahrbar gelagert ist. Der Träger ist an seinen Enden sowie im Mittelbereich durch wandartige Stützen abgestützt, wobei die Mittelstützen und die Seitenstützen eine zueinander rechtwinklige Orientierung aufweisen.

In DE 19707267 A ist eine Bestückvorrichtung offenbart, bei der ein balkenartiger Träger an seinen Enden abgestützt ist.

An den senkrecht zur Bestückebene verlaufenden Längsseiten des Trägers sind jeweils Positionierarme längsverschieblich gelagert.

Bei dem genannten Stand der Technik ist die Führung für das Positionierorgan an der waagerechten Unterseite oder an einer senkrechten Außenseite des im Querschnitt rechteckigen Führungskörper angeordnet. In diesen Fällen summieren sich die Abmessungen der beiden Funktionsteile zu einer höheren Bauhöhe bzw. Baubreite.

Der Erfindung liegt die Aufgabe zugrunde, die Positioniergenauigkeit zu erhöhen und/oder die Bestückzeit zu verkürzen und dabei den Bauraum klein zu halten.

Diese Aufgabe wird durch die Erfindung gemäß Anspruch 1 gelöst. Durch die Erfindung ergeben sich optimale Verhältnisse im Hinblick auf die wirksamen Hebel und insbesondere auf den Verlauf der Kraftlinien im Führungskörper und im Positionierorgan, wobei die glatt verlaufenen Kraftlinien eine geringe Umlenkung aufweisen. Durch die schräge Außenseite, verjüngt sich der Führungskörper zum Positionierorgan hin. Dies ist insofern unschädlich, als in diesem Bereich die mechanischen Spannungen ohnehin gering sind. Das Positionierorgan kann nun teilweise in den Überdeckungsbereich des Führungskörpers hineinragen, wodurch ein entsprechender Bauraum für verschiedene Funktionsteile des Positionierorgans zu Verfügung steht. Die Baubreite und die Bauhöhe des Führungskörpers mit dem Positionierorgan können auf diese Weise klein gehalten werden.

Der Schwerpunkt des Positionierorgans rückt näher an den Querschnittsmitte des Führungskörpers heran. Das schräg stehende Führungslager nimmt die Massenkräfte und Massenmomente des Positionierorgans in waagerechter wie auch in senkrechter Richtung optimal auf. Verbindungsteile zwischen der Führungsseite des Positionierorgans und dessen Hauptbereich können als integrale Verstärkungen ausgebildet werden. Der sich nach unten verjüngende Führungskörper verbessert die Zugänglichkeit zum Arbeitsraum der Vorrichtung.

Durch die Weiterbildung nach den Ansprüchen 2 und 3 werden die Antriebs- und Führungsteile nach der Neigung der Außenseite ausgerichtet und bilden dadurch eine kompakte Einheit.

Durch die Weiterbildung nach Anspruch 4 wird die Zugänglichkeit zu den Arbeitsbereichen der Vorrichtung weiter verbessert. Die schräge äußere Führungsseite weist einen geringen Abstand, zur Mitte des Trägers auf, wodurch dieser entsprechend kompakt ausgebildet werden kann. Das schräg stehende Führungslager nimmt die waagerechten Massenkräfte des Bestückkopfes wie auch die Kippmomente des Positionierarmes optimal auf. Die Lagerstellen sind dem Massenschwerpunkt des Positionierarmes angenähert. Verbindungsteile zwischen diesem und dem Linearlager können als integrale Verstärkungen ausgebildet werden. Die nach außen ansteigende Schräge der äußeren Längsseite des Trägers verbessert die Zugänglichkeit zum Arbeitsraum der Vorrichtung.

Durch das Koppelteil nach Anspruch 5 wird der Positionierarm erheblich verstärkt.

Durch die Weiterbildung nach Anspruch 6 verringert sich das Gewicht des Positionierarmes. Der Bestückkopf kann raumsparend an diesen angekoppelt werden. Im abgeschrägten Bereich des Bestückkopfes steht ein Bauraum zur Verfügung, in dem verschiedene Komponenten des Bestückkopfes raumsparend untergebracht sein können, wodurch insbesondere die Baubreite des Positionierarms mit dem Bestückkopf klein gehalten werden kann.

Im folgenden wird die Erfindung anhand eines in der Zeichnung dargestellten Ausführungsbeispieles näher erläutert. Es zeigen:
- Figur 1: eine Seitenansicht einer Bestückvorrichtung gemäß der Erfindung,
- Figur 2: eine andere Seitenansicht der Vorrichtung nach Figur 1
- Figur 3: einen Schnitt entlang der Linie III-III in Figur 1

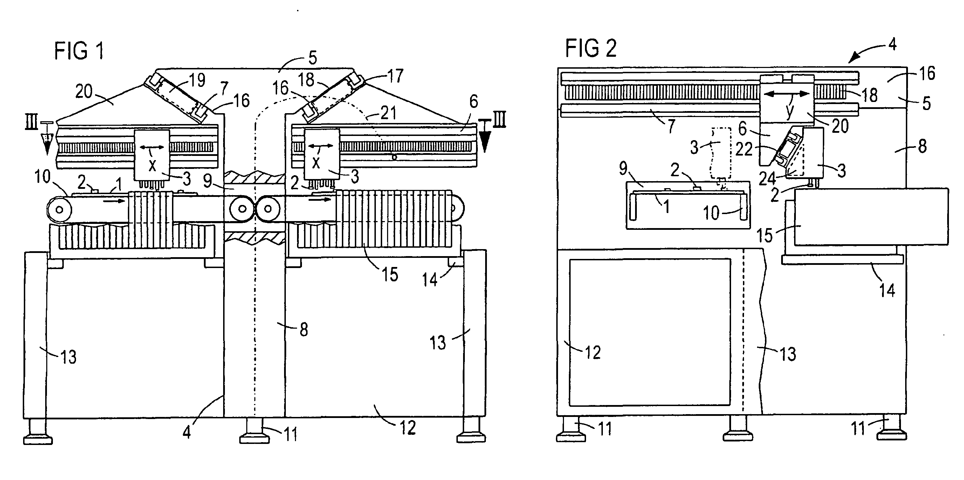

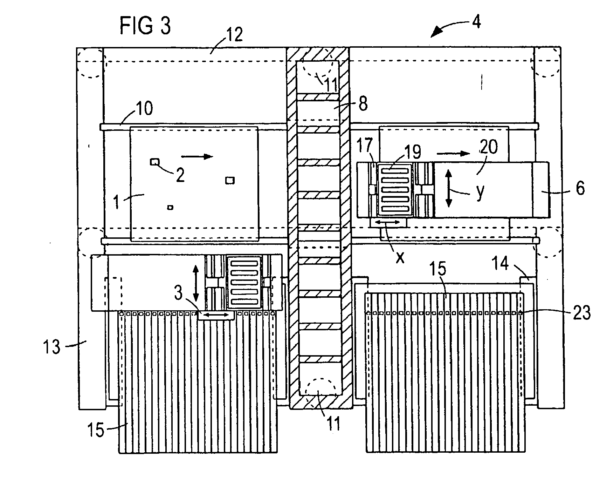

Figur 1, 2 und 3 zeigen eine Vorrichtung zum Bestücken von flachen Substraten 1 mit elektrischen Bauelementen 2 mittels eines in einer Arbeitsebene parallel zum Substrat 1 verfahrbaren Bestückkopfes 3. Ein Chassis 4 der Vorrichtung weist einen stationären Träger 5 auf, an dem ein Positionierarm 6 in einer Längsrichtung Y verschiebbar geführt ist. Der Bestückkopf 3 ist am länglichen Positionierarm 6 in einer Querrichtung x verschiebbar geführt. Der Träger ist oberhalb des Positionierarms 6 angeordnet und überdeckt in der Querrichtung einen Teil des Positionierarms 6 und weist in diesem Bereich Längsführungselemente 7 für den Positionierarm 6 auf. Von dort aus erstreckt sich der Träger 5 in der Querrichtung bis über eines der Stirnenden des Positionierarms 6 und ist dort mit einer nach unten weisenden, sich in der Längsrichtung erstreckenden starren Tragwand 8 über seine gesamte Länge fest verbunden, wobei diese Verbindung durch eine einstückige Bauweise, stoffschlüssig oder lösbar realisiert sein kann.

Die Tragwand 8 ist in ihrem mittleren Bereich mit einem Durchbruch 9 versehen, durch den eine Transportstrecke 10 für die Substrate 1 senkrecht hindurch geführt ist. Die gesamte Vorrichtung ist zu beiden Seiten der Tragwand 8 spiegelsymmetrisch aufgebaut mit dem nach beiden Seiten auskragenden Träger 5, der Längsführungen 7, den Positionierarmen 6 und Bestückköpfen 3. Die Substrate 1 können dementsprechend auf der Transportstrecke an Bestückplätzen zu beiden Seiten der Tragwand 8 temporär fixiert werden.

Die Tragwand 8 ist an ihrer Unterseite mit Stützfüßen 11 versehen und entlastet. Sie ist zusammen mit dem Träger als gerippter Hohlkörper ausgebildet, bei dem Querrippen 12 die gesamte Tragstruktur verstärken. Das Chassis 4 weist ferner unterhalb der Transportstrecke einen quer zur Tragwand 8 orientierten rohrartigen Stützkörper 12 auf, der sich quer zur Tragwand 8 erstreckt und an dessen Außenseiten seitliche Stützwände 13 angesetzt sind, die mit Auflagestegen 14 für Bauelementezuführungen 15 versehen sind. Diese weisen eine Reihe von Abholplätze 23 auf, an denen die Bauelemente 2 durch den Bestückkopf 3 entnommen werden können, der dann diese Bauelemente zu ihren Montageplätzen auf dem Substrat 1 transportiert.

Die Längsführungselemente 7 für den Positionierarm 6 sind an einer äußeren Längsseite 16 des Trägers 5 angeordnet. Diese Längsseite 16 ist schräg zur Arbeitsebene geneigt und die entsprechende Führungsseite des Positionierarms ist in ihrer Neigung der Längsseite 16 angepasst. Die Längsführungselemente 7 sind in zwei Spuren angeordnet und bilden eine Führungsebene, die parallel zur Längsseite 16 verläuft. Längsführungsteile 17 des Positionierarmes 6 greifen in die Längsführungselemente 7 ein.

Der Positionierarm 6 ist mittels eines Linearmotors angetrieben, wobei entlang der äußeren Längsseite 16 des Trägers 4 angebrachte Magnetteile 18 die stationäre Antriebsteile bilden. Ein dem Positionierarm zugeordnetes mobilen Spulenteil 19 ist zwischen den Längsführungsteilen 17 des Positionierarms 6 angeordnet und bildet die mobilen Antriebsteile. Eine Trennebene zwischen den stationären und mobilen Teilen des Linearmotors ist der schrägen Längsseite 16 des Trägers 5 angenähert.

Die Längsseite 16 ist an einer freien Vorderseite des Trägers 5 angeordnet und nach hinten und unten schräg stehend ausgebildet, wodurch eine gute Zugänglichkeit zu den Funktionsräumen der Vorrichtung zum Beispiel für Wartungszwecke erreicht wird. Der Positionierarm 6 ist über ein integrales dachartiges Koppelteil 20 mit den Längsführungsteilen 17 verbunden. Die schräg stehenden Wände des Koppelteils 20 reichen bis in die Nähe von Stirnenden des Positionierarmes 6, der dadurch entsprechend verstärkt wird. Insbesondere wird durch die Schrägstellung ein günstiger Verlauf der Kraftlinien 21 zwischen dem Positionierarm und der Tragwand 8 erreicht, wobei z.B. die dargestellte Kraftlinie 21 bei einer Mittelstellung des Bestückkopfes 3 mit einer geringen Umlenkung knickfrei verläuft, so dass die beim Bestücken auftretenden Massenkräfte besonders wirksam in das Chassis 4 übergeleitet werden können.

Ähnlich wie der Träger weist auch der Positionierarm 6 für den Bestückkopf 3 eine schrägstehende Führungsseite auf, die an einer schrägen Längswand 22 ausgebildet ist. Im abgeschrägten Bereich des Bestückkopfes steht ein Bauraum 24 zur Verfügung, in dem verschiedene Komponenten des Bestückkopfes 3 raumsparend untergebracht sein können, wodurch insbesondere die Baubreite des Positionierarms mit dem Bestückkopf klein gehalten werden kann.

Das Prinzip der schrägen Anbindung kann also sowohl beim Träger 5) mit dem Positionierarm 6 als auch beim Positionierarm 6 mit dem Bestückkopf 3 realisiert werden, wobei jeweils der Träger 5 oder der Positionierarm 6 als Führungskörper 5/6 bzw. der Positionierarm 6 oder der Bestückkopf 3 als Positionierorgan 6/3 und die Längsseite 16 bzw. die Längswand 22 als Außenseite 16/22 fungieren.

### Bezugszeichen

- X: Querrichtung
- Y: Längsrichtung
- 1: Substrat
- 2: Bauelement
- 3: Bestückkopf
- 4: Chassis
- 5: Träger
- 6: Positionierarm
- 5/6: Führungskörper
- 6/3: Positionierorgan
- 7: Längsführungselement
- 8: Tragwand
- 9: Durchbruch
- 10: Transportstrecke
- 11: Stützfuß
- 12: Stützkörper
- 13: Stützwand
- 14: Auflagesteg
- 15: Bauelementezuführung
- 16: Längsseite
- 16/22: Außenseite
- 17: Längsführungsteil
- 18: Magnetteil
- 19: Spulenteil
- 20: Koppelteil
- 21: Kraftlinie
- 22: Längswand
- 23: Abholplatz
- 24: Bauraum

## Patentansprüche

1. Vorrichtung zum Bestücken von flachen Substraten (1) mit elektrischen Bauelementen (2),
wobei entlang einer Außenseite (16/22) eines Führungskörpers (5/6) der Vorrichtung parallel zur Substratebene ein Positionierorgan (6/3) linear verschiebbar geführt ist,
**dadurch gekennzeichnet, dass** die Außenseite (16/22) schräg zur Substratebene geneigt ist und dass eine der Außenseite (16/22) zugewandte Führungsseite des Positionierorgans (6/3) in ihrer Neigung der Außenseite (16/22) des Führungskörpers (5/6) angepasst ist.

2. Vorrichtung nach Anspruch 1,
**dadurch gekennzeichnet, dass** die Außenseite (16/22) mit zwei eine Führungsebene bildenden Führungsspuren versehen ist, in die Längsführungsteile (17) des Positionierorgans (6/3) eingreifen und
dass die Führungsebene annähernd parallel zur Außenseite (16/22) verläuft.

3. Vorrichtung nach Anspruch 1 oder 2,
**dadurch gekennzeichnet, dass** das Positionierorgan (6/3) mittels eines Linearmotors antreibbar ist, dass stationäre Antriebsteile des Linearmotors dem Führungskörper (5/6) zugeordnet sind,
dass mobile Antriebsteile des Linearmotors dem Positionierorgan (6/3) zugeordnet sind und
dass eine Trennebene zwischen den stationären und den mobilen Antriebsteilen der schrägen Außenseite (16/22) des Führungskörpers (5/6) angenähert ist.

4. Vorrichtung nach Anspruch 1, 2 oder 3, **dadurch**
**gekennzeichnet, dass** der Führungskörper als stationärer Träger (5) ausgebildet ist, der an einem Chassis (4) der Vorrichtung fest verankert ist,
dass das Positionierorgan als mobiler Positionierarm (6) aus gebildet und unterhalb des Trägers angeordnet ist, und
dass die Außenseite an einer freien vorderen Längsseite (16) des Trägers (5) angeordnet und nach hinten und unten schrägstehend ausgebildet ist.

5. Vorrichtung nach Anspruch 4,
**dadurch gekennzeichnet,**
**dass** eine der Längsseite (16) zugewandte Führungsseite des Positionierarms (6) mit einem länglichen Hauptteil des Positionierarms (6) über ein integrales Koppelteil (20) verbunden ist, das mit dachartig schräg stehenden Wänden bis in die Nähe von Stirnenden des Positionierarmes (6) reicht.

6. Vorrichtung nach Anspruch einem der vorhergehenden Ansprüche,
**dadurch gekennzeichnet, dass** der Führungskörper als der am Träger (5) verschiebbarer Positionierarm (6) ausgebildet ist,
dass das daran verschiebbare Positionierorgan als der Bestückkopf (3) zum Handhaben der Bauelemente (2) ausgebildet ist,
dass der Positionierarm (6) in seinem Querschnitt zum Substrat (1) hin verjüngt ausgebildet ist,
dass die Außenseite an einer die Verjüngung bildenden, zum Substrat (1) schräg stehenden Längswand (22) des Positionierarms (6) ausgebildet ist und
dass Funktionsteile des Bestückkopfes (3) in einem der schrägen Längswand (22) angenäherten Bauraum 24 angeordnet sind.

## Claims

1. Device for equipping flat substrates (1) with electrical components (2),
with a positioning organ (6/3) being guided along an outer side (16/22) of a guide body (5/6) of the device in parallel to the substrate plane to allow linear movement,
**characterized in that** the outer side (16/22) is inclined obliquely to the substrate plane and a guide side of the positioning organ (6/3) facing the outer side (16/22) is matched in its inclination to the outer side (16/22) of the guide body (5/6).

2. Device in accordance with claim 1,
**characterized in that**, the outer side (16/22) is provided with two guide tracks forming a guide plane, into which the longitudinal guide parts (17) of the positioning organ (6/3) engage and
the guide plane runs approximately in parallel to the outer side (16/22).

3. Device in accordance with claim 1 or 2,
**characterized in that** the positioning organ (6/3) can be driven by means of a linear motor, that stationary drive parts of the linear motor are assigned to the guide body (5/6),
mobile drive parts of the linear motor are assigned to the positioning organ (6/3) and
that a dividing plane between the stationary and the mobile drive parts is then approximated to the oblique outer side (16/22) of the guide body (5/6).

4. Device in accordance with claim 1, 2 or 3,
**characterized in that** the guide body is embodied as a stationary carrier (5) which is firmly anchored to a chassis (4) of the device,
the positioning organ is embodied as a mobile positioning arm (6) and is arranged below the carrier, and
the outer side is arranged on a free front longitudinal side (16) of the carrier (5) and is embodied obliquely backwards and downwards.

5. Device in accordance with claim 4,
**characterized in that**
a guide side of the positioning arm facing the longitudinal side (16) is connected to a longitudinal main part of the positioning arm (6) via an integral coupling part (20) that extends with roof-like oblique walls into the vicinity of end faces of the positioning arm (6).

6. Device in accordance with one of the previous claims,
**characterized in that** the guide body is embodied as the positioning arm (6) which is able to be moved on the carrier (5),
the positioning organ that can be moved on it is embodied as the equipping head (3) for handling the components (2),
the positioning arm (6) is embodied in its cross-section tapering towards the substrate (1),
the outer side is embodied on a longitudinal wall (22) of the positioning arm (6) forming the taper at an angle to the substrate (22), and
functional parts of the equipping head (3) are arranged in a space 24 approximated to the oblique longitudinal wall (22).

## Revendications

1. Dispositif pour équiper des substrats (1) plats avec des composants (2) électriques,
un organe de positionnement (6/3) étant guidé de façon coulissante linéairement le long d'un côté extérieur (16/22) dans un corps de guidage (5/6) du dispositif parallèlement au plan de substrat,
**caractérisé en ce que** le côté extérieur (16/22) est incliné en biais par rapport au plan de substrat et **en ce qu'**un côté de guidage, associé au côté extérieur (16/22), de l'organe de positionnement (6/3) est adapté dans son inclinaison au côté extérieur (16/22) du corps de guidage (5/6).

2. Dispositif selon la revendication 1,
**caractérisé en ce que** le côté extérieur (16/22) est doté de deux traces de guidage formant un plan de guidage, dans lesquelles s'engagent des parties de guidage longitudinales (17) de l'organe de positionnement (6/3) et
**en ce que** le plan de guidage est agencé approximativement parallèlement au côté extérieur (16/22).

3. Dispositif selon la revendication 1 ou 2,
**caractérisé en ce que** l'organe de positionnement (6/3) peut être entraîné au moyen d'un moteur linéaire, **en ce que** des parties d'entraînement fixes du moteur linéaire sont attribuées au corps de guidage (5/6),
**en ce que** des parties d'entraînement mobiles du moteur linéaire sont attribuées à l'organe de positionnement (6/3) et
**en ce qu'**un plan de séparation entre les parties d'entraînement fixes et les parties d'entraînement mobiles est rapproché du côté extérieur (16/22) incliné du corps de guidage (5/6).

4. Dispositif selon la revendication 1, 2 ou 3, **caractérisé en ce que** le corps de guidage est conçu comme support (5) fixe, qui est ancré de façon ferme sur un châssis (4) du dispositif,
**en ce que** l'organe de positionnement est réalisé sous la forme d'un bras de positionnement (6) mobile et disposé au-dessous du support et **en ce que** le côté extérieur est disposé sur un côté longitudinal (16) avant libre de support (5) et est réalisé en biais vers l'arrière et vers le bas.

5. Dispositif selon la revendication 4,
**caractérisé en ce que**
un côté du guidage, associé au côté longitudinal (16), du bras de positionnement (6) est relié à une partie principale allongée du bras de positionnement (6) au moyen d'une partie du couplage (20) intégrée, laquelle s'étend avec des parois disposées en biais en forme de toit jusqu'à proximité d'extrémités avant du bras de positionnement (6).

6. Dispositif selon l'une quelconque des revendications précédentes,
**caractérisé en ce que** le corps de guidage est réalisé sous la forme du bras de positionnement (6) coulissant sur le support (5),
**en ce que** l'organe de positionnement coulissant dessus est réalisé sous la forme de la tête d'équipement (3) pour la manipulation des composants (2),
**en ce que** le bras de positionnement (6) est réalisé dans sa section avec un rétrécissement en direction du substrat (1),
**en ce que** le côté extérieur est réalisé sur une paroi longitudinale (22) formant le rétrécissement, en biais par rapport au substrat (1), du bras de positionnement (6) et
**en ce que** les parties fonctionnelles de la tête d'équipement (3) sont disposées dans un espace de construction 24 rapproché de la paroi longitudinale (22) inclinée.
